# EUROPÄISCHE PATENTSCHRIFT

(11) **EP 1 630 959 B1**
(45) Veröffentlichungstag und Bekanntmachung des Hinweises auf die Patenterteilung: **13.10.2010**
(21) Anmeldenummer: 05106619.9
(22) Anmeldetag: 19.07.2005
(51) Int. Cl.: H03J 1/00, H04B 15/06

(54) **Rundfunkempfänger mit mindestens zwei Empfangstunern die gegenseitige Störungen vermeiden**
Broadcast receiver having two tuners preventing mutual interference
Récepteur de radiodiffusion ayant deux tuner empêchant des interférences mutuelles

(30) Priorität: 26.08.2004 DE 102004041246
(43) Veröffentlichungstag der Anmeldung: 01.03.2006
(73) Patentinhaber: ROBERT BOSCH GMBH, 70442 Stuttgart (DE)
(72) Erfinder: Kottschlag, Gerhard, 31139, Hildesheim (DE); Vogel, Guenter, 72760, Reutlingen (DE); Passoke, Jens, 30539, Hannover (DE); Schnitzer, Reiner, 72762, Reutlingen (DE)

(56) Entgegenhaltungen:
- EP-A- 1 075 083
- DE-A1- 3 200 560
- DE-A1- 4 236 621
- US-A- 6 151 488

## Beschreibung

Die vorliegende Erfindung betrifft einen Rundfunkempfänger mit mindestens zwei Empfangstunern, wobei jeder Empfangstuner einen Oszillator und einen Mischer zur Mischung eines Empfangssignals auf eine Zwischenfrequenz hat und die Empfangsfrequenz innerhalb eines Empfangsfrequenzbereichs, zu dessen Empfang der Rundfunkempfänger angelegt ist, durch die Oszillatorfrequenz des Oszillators bestimmt ist.

Bei Rundfunkempfängern mit mehreren Empfangstunern, insbesondere mit Superhet-Empfängern, kann dann in ungünstigen Fällen vorkommen, dass das Mischeransteuerungssignal eines Empfangstuners genau auf der Empfangsfrequenz eines anderen Empfangstuners liegt und in diesem Empfangstuner zu Störungen führt.

Durch eine ausreichende Entkopplung oder Schirmung der Empfangstuner können solche Störungen vermieden werden. Dies ist jedoch mit einem hohen Kostenaufwand verbunden.

Es ist auch bekannt, durch die Wahl einer Zwischenfrequenz, die höher als die Breite des Empfangsbandes ist, solche Störungen zu vermeiden. Hierdurch wird von vornherein ausgeschlossen, dass ein Oszillator eines Empfangstuners in den Nutzkanat des jeweils anderen Empfangstuners fallen kann, da der Oszillator immer außerhalb des Empfangsbandes schwingt. Die Abweichung von einer Standard-Zwischenfrequenz führt jedoch zu der Notwendigkeit, speziell angepasste Empfangsbauelemente nutzen zu müssen. Zudem besteht das Risiko, dass die nicht durch internationale Vereinbarungen geschützte alternative Zwischenfrequenz durch starke Funksignale von außen gestört werden kann. DE 42 36 621 A1 offenbart einen Rundfunkempfänger gemäß Oberbegriff des Anspruchs 1. Störungen eines Empfangstuners durch Einstreuungen aus dem Lokaloszillator eines Suchtuners werden dadurch vermieden, dass für den Suchtuner verbotene Bereiche definiert werden.

DE 32 00 560 A1 offenbart ein Verfahren zur Unterdrückung von Spiegelwellen- und Intermodulationsstörungen. Bei einer erkannten Störung wird die Oszillatorfrequenz um einen festen Betrag des doppelten der Zwischenfrequenz verschoben. Die Detektion einer Störung erfolgt manuell oder mit Hilfe eines zyklisch ausgesendeten Datenwortes.

Aufgabe der Erfindung ist es daher, einen verbesserten Rundfunkempfänger mit mindestens zwei Empfangstunern zu schaffen, bei dem Störungen von Empfangstunern durch Oszillatorfrequenzen anderer Empfangstuner des Rundfunkempfängers vermieden werden.

Die Aufgabe wird mit dem gattungsgemässen Rundfunkempfänger erfindungsgemäss gelöst durch eine Vorrichtung, zur Einstellung der jeweils ausgewählten Empfangsfrequenz derart eingerichtet ist, dass zur Vermeidung einer Störung der ausgewählten Empfangsfrequenzen durch die Oszillatorfrequenzen bei einem in einen unteren Bereich und einen oberen Bereich aufgeteilten Empfangsfrequenzbandes die Oszillatorfrequenz für eine im festgelegten unteren Bereich liegende Empfangsfrequenz unterschwingend auf eine Frequenz unterhalb des Empfangsfrequenzbereiches und für eine im festgelegten Bereich liegende Empfangsfrequenz oberschwingend auf eine Frequenz oberhalb des Empfangsfrequenzbereichs eingestellt wird.

Durch die wahlweise Nutzung einer unterschwingenden oder oberschwingenden Oszillatorfrequenz in Abhängigkeit von der Empfangsfrequenz kann eine einheitliche Zwischenfrequenz, wie zum Beispiel die international festgelegte Zwischenfrequenz von 10,7 MHz genutzt werden und gleichzeitig eine Störung der Empfangsfrequenz eines Empfangstuners durch die Oszillatorfrequenz eines anderen Empfangstuners ausgeschlossen werden.

Dabei wird der obere Teil beispielsweise eines FM-Rundfunkbandes mit oberschwingendem Oszillator empfangen, wobei das Oszillatorsignal oberhalb des oberen Bandendes des Frequenzbandes liegt. Der untere Teil des FM-Rundfunkbandes wird hingegen unterschwingend empfangen, so dass in diesem Bereich der Oszillator immer unterhalb des unteren Bandendes des Frequenzbandes betrieben wird.

Gegebenenfalls muss der durch den Oszillator angesteuerte Mischer beim Wechsel zwischen unter- und oberschwingendem Oszillator auf die jeweilige Frequenzlage umgeschaltet werden, wenn der Mischer als Mischer mit Spiegelfrequenzunterdrückung (IMR-Mischer) ausgelegt ist.

Beim Umschalten der Oszillatorfrequenz ggf. indirekt durch Umschalten des Mischeransteuerungssignals kann der Rundfunkempfänger vorzugsweise zum kurzzeitigen Abschalten eines Empfangstuners bzw. der Audiosignalwiedergabe ausgebildet sein. Damit werden die Audiosignale zur Knackunterdrückung kurz abgeschaltet. Dies ist insbesondere vorteilhaft, wenn ein Hintergrund-Empfangstuner auf der Oszillatorfrequenz eines Hör-Empfangstuners empfangen will und daher der Hör-Empfangstuner umgeschaltet werden muss. Die notwendige Änderung der Oszillatorfrequenz des Hör-Empfangstuners bedingt ein Neuanschwingen des geschlossenen Phasenregelkreises Phase Locked Loop - PLL), was ohne die Signalabschaltung ein hörbares Störgeräusch im Audiosignal zur Folge haben könnte.

Die Frequenz des Oszillatorsignals sollte vorzugsweise einem Vielfachen des Signals zur Ansteuerung des Mischers entsprechen. Hierzu sollte mindestens ein Frequenzteiler vorgesehen sein, der die Frequenz des Oszillatorsignals auf die Oszillatorfrequenz herunterteilt. Das Teilverhältnis des Frequenzteilers ist vorzugsweise ganzzahlig oder gebrochen rational. Wenn das Teilverhältnis gebrochen rational ist kann der Oszillator beispielsweise mit einer Fractional-N-PLL betrieben werden.

Die Erfindung wird nachfolgend anhand der beigefiigten Zeichnungen beispielhaft näher erläutert. Es zeigen:
Figur 1 - Blockdiagramm eines Rundfunkempfängers mit mindestens zwei Empfangstunern;
Figur 2 - Diagramm von Frequenzamplituden von Empfangs- und Oszillatorfrequenzen für zwei Empfangstuner mit oberschwingendem Betrieb für eine Zwischenfrequenz von 10,7 MHz;
Figur 3 - Diagramm von Frequenzamplituden von Empfangs- und Oszillatorfrequenzen für zwei Empfangstuner mit oberschwingendem Betrieb für eine Zwischenfrequenz von 25,0 MHz;
Figur 4 - Diagramm von Frequenzamplituden von Empfangsfrequenzen in einem FM-Frequenzband von 87,5 bis 108,0 MHz und umschaltbaren unter- und oberschwingenden Oszillatorfrequenzen für zwei Empfangstuner für eine Zwischenfrequenz von 10,7 MHz;
Figur 5 - Diagramm von Frequenzamplituden von Empfangssignalen im FM-Frequenzband von 76,0 bis 90,0 MHz und umschaltbaren unter- und oberschwingenden Oszillatorfrequenzen für zwei Empfangstuner für eine Zwischenfrequenz von 10,7 MHz.

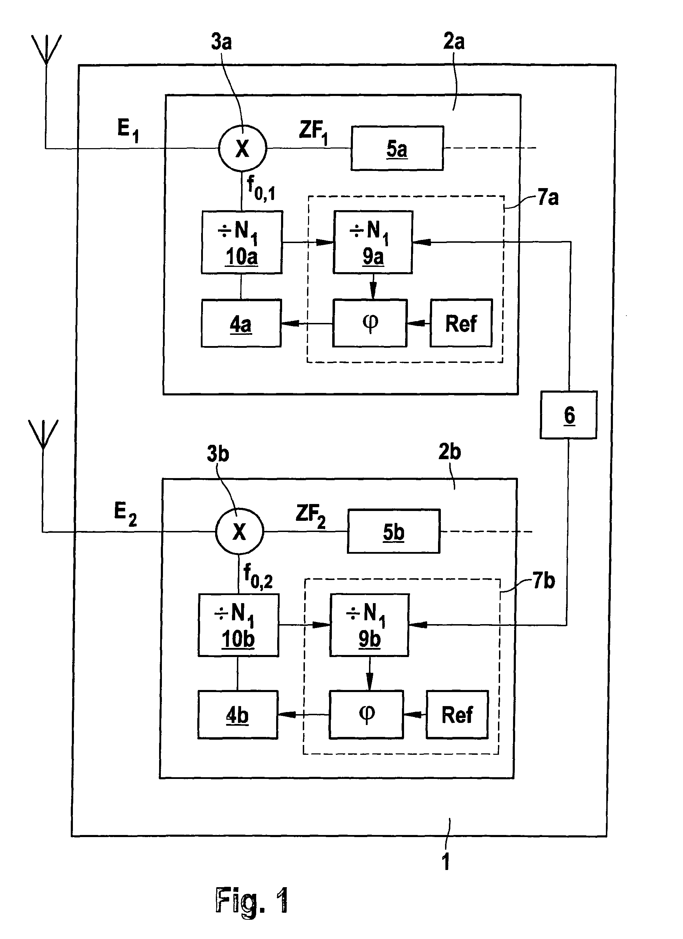

Die Figur 1 lässt ein Blockdiagramm eines Ausführungsbeispiels für einen Rundfunkempfänger 1 mit zwei Empfangstunern 2a, 2b erkennen. Die Empfangstuner 2a, 2b haben jeweils einen Mischer 3a, 3b, die mit einer Oszillatorfrequenz f_{0,1}, f_{0,2} zum Mischen des Empfangssignals E1, E2 auf eine Zwischenfrequenz ZF₁, ZF₂ beaufschlagt werden. Die Oszillatorfrequenzen f_{0,1}, f_{0,2} werden jeweils von einem Oszillator 4a, 4b generiert.

Die Empfangstuner 2a, 2b haben weitere Empfangsbausteine 5a, 5b, wie zum Beispiel einen Filter etc. zur weiteren Bearbeitung des Zwischenfrequenzsignals ZF₁, ZF₂ auf bekannte Weise.

Die Oszillatoren 4a, 4b werden durch einen Mikroprozessor 6 und jeweils eine PLL 7 (Phase Locked Loop ― Phasenstarr gekoppelter Regelkreis) als Vorrichtung 8 zum wahlweisen Einstellen der Oszillatorfrequenz gesteuert. Ein Frequenzteiler 9a, 9b in der PLL 7 wird beispielsweise von einem Mikroprozessor oder Signalprozessor so angesteuert, dass wahlweise die Oszillatorfrequenz f_{0,1} bzw. f_{0,2} unterschwingend auf eine Frequenz unterhalb des Frequenzbandes oder oberschwingend auf eine Frequenz oberhalb des Frequenzbandes, zu dessen Empfang der Rundfunkempfänger ausgelegt ist, so eingestellt wird, dass das Empfangssignal E auf einer ausgewählten Empfangsfrequenz auf die Zwischenfrequenz ZF₁ bzw. ZF₂ gemischt wird und die Empfangstuner 5a, 5b nicht gegenseitig gestört werden. Ebenso kann zwischen dem Abgriff des VCO-Signals (VCO=Voltage Controlled Oszillator ― Spannungsgesteuerter Oszillator) des Oszillators 4a, 4b zum Frequenzteiler 9a, 9b und zum Mischer 3a, 3b jeweils ein Teiler 10a, 10b eingefügt sein.

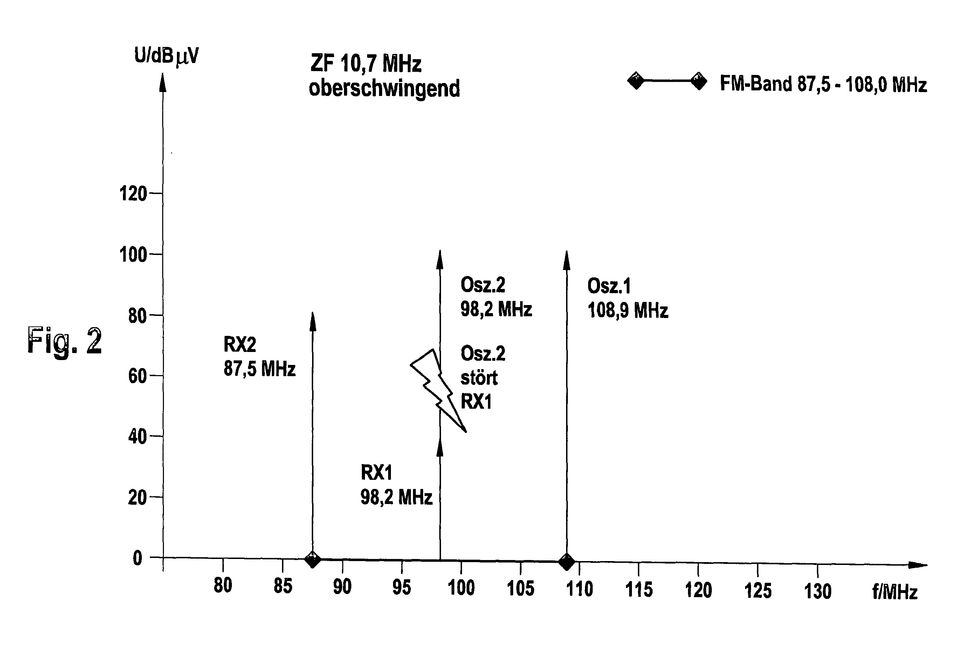

Bei herkömmlichen Empfängern erfolgt, wie in der Figur 2 anhand eines Diagramms der Frequenzamplituden U über einen Frequenzbereich f dargestellt ist, das Mischen des Empfangssignals E1, E2 mit einer oberschwingenden Oszillatorfrequenz f₀ oberhalb der jeweils zu empfangenden Empfangsfrequenz. Die Oszillatorfrequenz f₀ ist dabei so eingestellt, dass eine Zwischenfrequenz ZF von 10,7 MHz erreicht wird. Diese Zwischenfrequenz ZF ist international normiert und es sind kostengünstige Standard-Empfangsbausteine 5 für diese Zwischenfrequenz ZF verfügbar.

Ein Autoradio beispielsweise verfügt über einen Hauptempfänger RX1, dessen niederfrequentes Ausgangssignal zur Wiedergabe im Fahrgastraum genutzt wird. Ein zweiter Empfänger RX2 dient als Hintergrundempfänger zur zyklischen Beobachtung alternativer Empfangsfrequenzen, zum Bandscan oder zur Erfassung von TMC-Datentelegrammen auf einem anderen FM-Sender. Beide Empfänger verwenden die Zwischenfrequenz ZF von 10,7 MHz und oberschwingende Oszillatoren 4. Folglich liegt die jeweilige Oszillatorfrequenz f_{0,1} und f_{0,2} 10,7 MHz über der jeweiligen Empfangsfrequenz. Wenn der Hintergrundempfänger RX2 auf einer Frequenz betrieben wird, die 10,7 MHz unter der Empfangsfrequenz des Hauptempfängers RX1 liegt, so fällt das starke Mischoszillatorsignal mit der Oszillatorfrequenz f_{0,2} genau auf die Empfangsfrequenz des Hauptempfängers RX 1 und kann zu erheblichen Störungen des Audioempfangs führen.

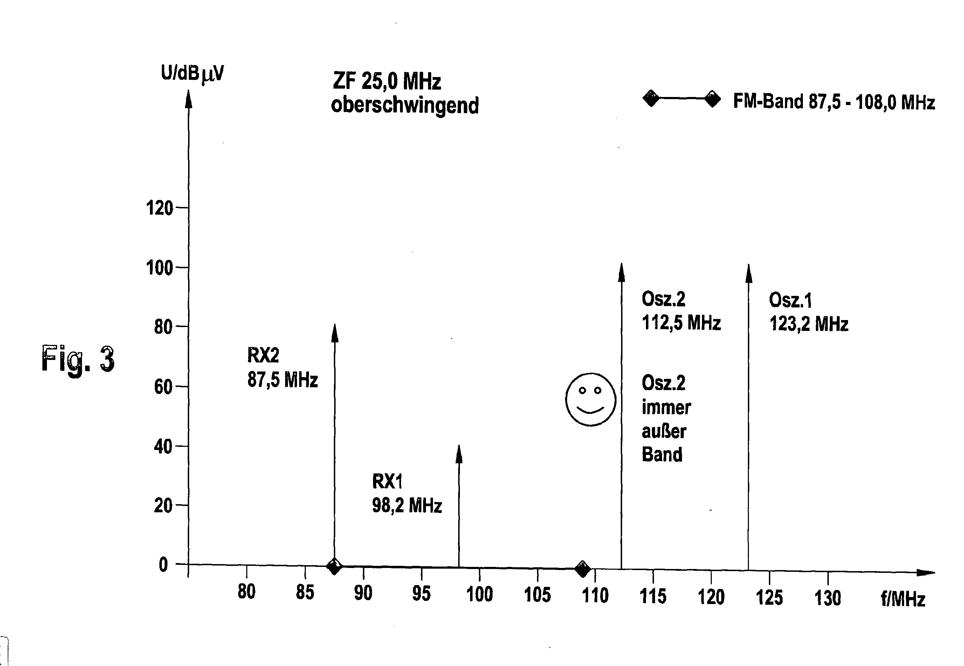

Die Figur 3 lässt eine herkömmlich bekannte Art zur Unterdrückung derartiger Störungen durch eine oberschwingend auf eine Frequenz oberhalb des FM-Rundfunkbandes von 87,5 bis 108,0 MHz eingestellte Oszillatorfrequenz f_{0,1} und f_{0,2} erkennen. Dies führt zu einer Zwischenfrequenz ZF von mehr als 10,7 MHz. Beispielsweise wird eine Zwischenfrequenz ZF von 25,0 MHz erreicht. Dies führt dazu, dass keine Standard-Empfangsbausteine 5 für die Zwischenfrequenz ZF mehr genutzt werden können. Zudem kann die nicht genormte Zwischenfrequenz ZF unter Umständen durch starke Funksignale gestört werden.

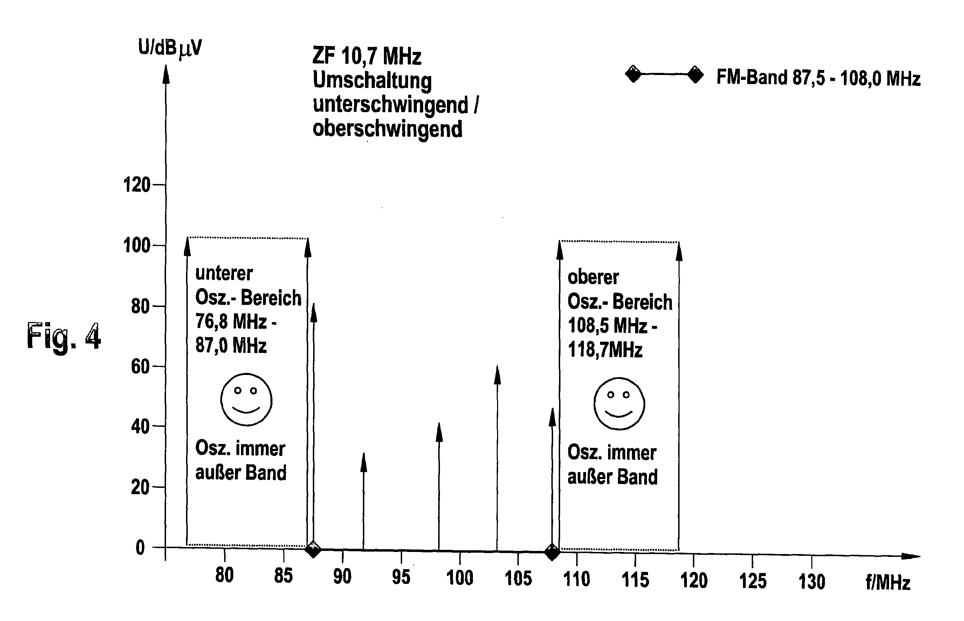

Die Figur 4 lässt ein Diagramm von Frequenzamplituden U in Abhängigkeit von der Frequenz f von Empfangsfrequenzen E und Oszillatorfrequenzen f₀ erkennen. Der Oszillatorabstimmbereich ist in einen unteren Frequenzbereich von 76,8 bis 87,0 MHz und einen oberen Frequenzbereich von 108,5 bis 118,7 MHz aufgeteilt. Die Oszillatorfrequenz f₀ eines Empfangstuners 2 wird unterschwingend auf eine Frequenz unterhalb des Frequenzbandes von 87,5 bis 108,0 MHz eingestellt, wenn die Empfangsfrequenz im unteren Frequenzbereich ist. Anderenfalls wird die Oszillatorfrequenz f₀ oberschwingend auf eine Frequenz oberhalb des Frequenzbandes, d. h. oberhalb von 108,0 MHz eingestellt. Die Oszillatorfrequenz f₀ wird dabei so gewählt, dass eine Zwischenfrequenz ZF von 10,7 MHz erreicht wird.

Durch die Umschaltung zwischen oberschwingender und unterschwingender Oszillatorfrequenz f₀ wird sichergestellt, dass die Oszillatorfrequenz f₀ eine Empfangsfrequenz nie stört.

Oftmals ist es, wie zum Beispiel bei Rundfunkempfängern für das FM-Band von 76,0 bis 90,0 MHz in Japan und einer Zwischenfrequenz von 10,7 MHz, von Vorteil, das FM-Frequenzband nicht in zwei gleichgroße Abschnitte zu unterteilen.

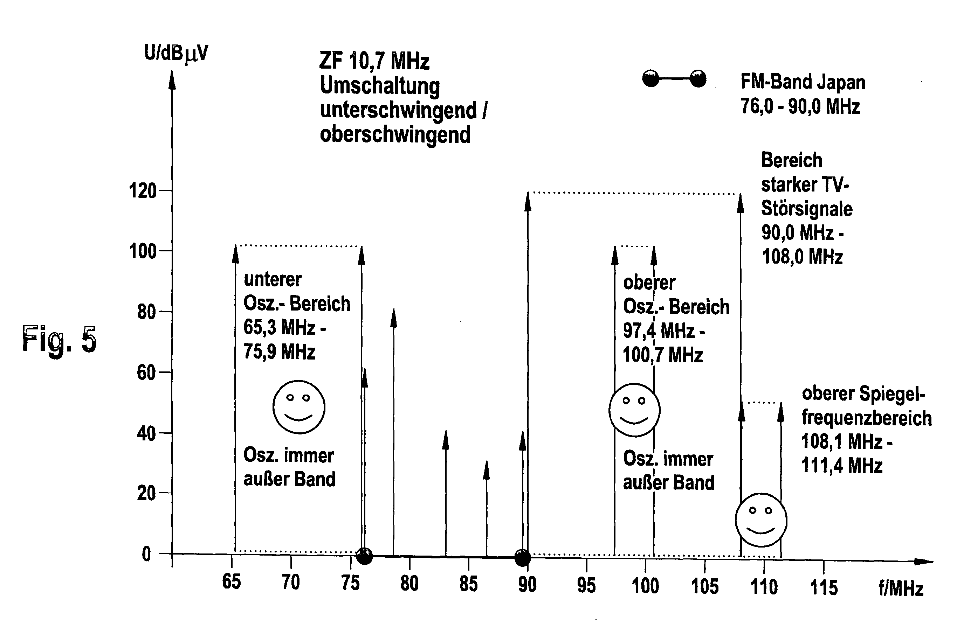

Wie in der Figur 5 gezeigt ist, kann beispielsweise für den dargestellten Fall der Bereich von 76,0 bis 86,6 MHz unterschwingend empfangen werden, so dass die Oszillatorfrequenz f₀ immer unterhalb der unteren Bandgrenze liegt. Erst ab 86,7 MHz wird der restliche Frequenzbereich bis 90,0 MHz und gegebenenfalls auch höhere Frequenzen oberschwingend erfasst. Dies hat den Vorteil, dass ab 86,7 MHz aufwärts die Spiegelfrequenz des Empfangstuners 2 oberhalb von 108,0 MHz liegt und somit beispielsweise starke japanische TV-Sender, die den Bereich unterhalb von 108,0 MHz belegen, nicht den Empfang durch Einstrahlung auf der Spiegelfrequenz stören können.

Die beispielhafte Grenze von 86,6 MHz kann geringfügig variiert werden, da die relevanten Störsignale, insbesondere Bild- und Tonträger, nicht bis direkt an das Bandende von 108,0 MHz heranreichen.

Vorteilhaft ist es auch, wenn ein Standard-Betriebsmode entweder oberschwingend oder unterschwingend für den Mischerbetrieb ausgewählt wird. Bei jedem Sprung eines Empfangstuners 2 auf eine neue Frequenz wird dann beispielsweise durch einen geeignet programmierten Mikroprozessor berechnet, ob einer der Oszillatoren 4a, 4b in den Empfangskanal oder in dessen Nähe eines anderen Empfangstuners 2 fällt und daher Störungen auftreten könnten. Nur in diesen Fällen wird beim störerzeugenden Empfangstuner 2 der Mischerbetrieb so umgestellt, dass keine Störung auftreten kann. Hierbei kann es vorkommen, dass der Hintergrund-Empfangstuner 2b auf der Oszillatorfrequenz f₀ des Hör-Empfangstuners 2a empfangen soll, so dass der Hör-Empfangstuner 2a umgeschaltet werden muss. Hierdurch wird die Oszillatorfrequenz f₀ der Hör-Empfangstuners 2a geändert, was ein Neuanschwingen der PLL 7 bedingt. Daher sollten die Audiosignale zur Unterdrückung hörbaren Knackstörungen kurz abgeschaltet werden (Mute-Modus).

## Patentansprüche

1. Rundfunkempfänger (1) mit mindestens zwei Empfangstunern (2a, 2b), wobei jeder Empfangstuner (2a, 2b) einen Oszillator (4a, 4b) und einen Mischer (3a, 3b) zur Mischung eines Empfangssignals (E1, E2) auf eine Zwischenfrequenz (ZF₁, ZF₂) hat und die Empfangsfrequenz innerhalb eines Empfangsfrequenzbereiches, zu dessen Empfang der Rundfunkempfänger ausgelegt ist, durch die Oszillatorfrequenz (f_{0,1} und f_{0,2}) des Oszillators (4a, 4b) bestimmt ist, **dadurch gekennzeichnet, dass** eine Vorrichtung (8) zur Einstellung der Oszillatorfrequenzen (f_{0,1} und f_{0,2}) in Abhängigkeit von der jeweils ausgewählten Empfangsfrequenz derart eingerichtet ist, dass zur Vermeidung einer Störung der ausgewählten Empfangsfrequenzen durch die Oszillatorfrequenzen (f₀₁, f_{0,2}) bei einem in einen unteren Bereich und einen oberen Bereich aufgeteilten Empfangsfrequenzbandes die Oszillatorfrequenzen (f₀₁, f_{0,2}) für eine im festgelegten unteren Bereich liegende Empfangsfrequenz unterschwingend auf eine Frequenz unterhalb des Empfangsfrequenzbereichs und für eine im festgelegten oberen Bereich liegende Empfangsfrequenz oberschwingend auf eine Frequenz oberhalb des Empfangsfrequenzbereichs eingestellt sind.

2. Rundfunkempfänger (1) nach einem der vorhergehenden Ansprüche, **dadurch gekennzeichnet, dass** der Rundfunkempfänger (1) zum kurzzeitigen Abschalten eines Empfangstuners (2a, 2b) oder des zugehörigen Audiosignals bei Umschalten der Oszillatorfrequenz (f_{0,1} und f_{0,2}) mit der Vorrichtung (8) ausgebildet ist.

3. Rundfunkempfänger (1) nach einem der vorhergehenden Ansprüche, **dadurch gekennzeichnet, dass** die Oszillatorfrequenzen (f_{0,1}, f_{0,2}) so gewählt sind, dass die Spiegelfrequenzen der Oszillatorfrequenzen (f_{0,1}, f_{0,2}) ausserhalb genutzter Frequenzbänder, insbesondere ausserhalb von TV-Frequenzbänder liegen.

4. Rundfunkempfänger (1) nach einem der vorhergehenden Ansprüche, **dadurch gekennzeichnet, dass** die Frequenz des Oszillatorsignals einem Vielfachen des Signals zur Ansteuerung des Mischers (3a, 3b) entspricht und mindestens ein Frequenzteiler zur Herunterteilung der Frequenz des Oszillatorsignals auf die Oszillatorfrequenz (f_{0,1}, f_{0,2}) vorgesehen ist.

5. Rundfunkempfänger (1) nach Anspruch 4, **dadurch gekennzeichnet, dass** das Teilverhältnis des Frequenzteilers (9a, 9b) ganzzahlig oder gebrochen rational ist.

6. Rundfunkempfänger (1) nach Anspruch 5, **dadurch gekennzeichnet, dass** der Oszillator 4a, 4b mit einer Fractional-N-PLL betrieben wird, wenn das Teilverhältnis gebrochen rational ist.

## Claims

1. Broadcast radio receiver (1) having at least two reception tuners (2a, 2b), wherein each reception tuner (2a, 2b) has an oscillator (4a, 4b) and a mixer (3a, 3b) for mixing a received signal (E1, E2) to an intermediate frequency (ZF₁, ZF₂), and the reception frequency within a reception frequency range which the broadcast radio receiver is designed to receive is determined by the oscillator frequency (f_{0.1} and f_{0.2}) of the oscillator (4a, 4b), **characterized in that** an apparatus (8) for setting the oscillator frequencies (f_{0.1} and f_{0.2}) on the basis of the respectively selected reception frequency is set up such that to prevent interference on the selected reception frequencies by the oscillator frequencies (f_{0.1}, f_{0.2}) in a reception frequency band which is split into a lower range and an upper range, the oscillator frequencies (f_{0.1}, f_{0.2}) are set to undershoot to a frequency below the reception frequency range for a reception frequency situated in the stipulated lower range and are set to overshoot to a frequency above the reception frequency range for a reception frequency situated in the stipulated upper range.

2. Broadcast radio receiver (1) according to the preceding claim, **characterized in that** the broadcast radio receiver (1) is designed to briefly shut off a reception tuner (2a, 2b) or the associated audio signal when the oscillator frequency (f_{0.1} and f_{0.2}) is changed over with the apparatus (8).

3. Broadcast radio receiver (1) according to one of the preceding claims, **characterized in that** the oscillator frequencies (f_{0.1}, f_{0.2}) are chosen such that the mirror frequencies of the oscillator frequencies (f_{0.1}, f_{0.2}) are situated outside used frequency bands, particularly outside TV frequency bands.

4. Broadcast radio receiver (1) according to one of the preceding claims, **characterized in that** the frequency of the oscillator signal corresponds to a multiple of the signal for actuating the mixer (3a, 3b), and at least one frequency divider is provided for dividing down the frequency of the oscillator signal to the oscillator frequency (f_{0.1}, t_{0.2}).

5. Broadcast radio receiver (1) according to Claim 4, **characterized in that** the division ratio of the frequency divider (9a, 9b) is in integer or broken rational form.

6. Broadcast radio receiver (1) according to Claim 5, **characterized in that** the oscillator (4a, 4b) is operated with a fractional-N PLL when the division ratio is in broken rational form.

## Revendications

1. Récepteur radio (1) comprenant au moins deux tuners de réception (2a, 2b), chaque tuner de réception (2a, 2b) comprenant un oscillateur (4a, 4b) et un mélangeur (3a, 3b) pour mélanger un signal d'entrée (E1, E2) à une fréquence intermédiaire (ZF₁, ZF₂) et la fréquence de réception pour la réception de laquelle est conçu le récepteur radio étant déterminée par la fréquence d'oscillateur (f_{0,1} et f_{0,2}) de l'oscillateur (4a, 4b), **caractérisé en ce qu'**un dispositif (8) de réglage des fréquences d'oscillateur (f_{0,1} et f_{0,2}) en fonction de la fréquence de réception à chaque fois sélectionnée est réglé de telle sorte que pour éviter une perturbation des fréquences de réception sélectionnées par les fréquences d'oscillateur (f_{0,1} et f_{0,2}) dans le cas d'une bande de fréquences de réception divisée en une plage inférieure et une plage supérieure, les fréquences d'oscillateur (f_{0,1} et f_{0,2}), pour une fréquence d'entrée qui se trouve dans la plage inférieure, sont réglées en sous-oscillation à une fréquence au-dessous de la plage de fréquences de réception et, pour une fréquence d'entrée qui se trouve dans la plage supérieure, sont réglées en sur-oscillation à une fréquence au-dessus de la plage de fréquences de réception.

2. Récepteur radio (1) selon l'une des revendications précédentes, **caractérisé en ce que** le récepteur radio (1) est configuré pour désactiver brièvement un tuner de réception (2a, 2b) ou le signal audio associé lors de la permutation de la fréquence d'oscillateur (f_{0,1} et f_{0,2}) avec le dispositif (8).

3. Récepteur radio (1) selon l'une des revendications précédentes, **caractérisé en ce que** les fréquences d'oscillateur (f_{0,1}, f_{0,2}) sont choisies de telle sorte que les fréquences images des fréquences d'oscillateur (f_{0,1}, f_{0,2}) se trouvent en-dehors des bandes de fréquences utilisées, notamment en-dehors des bandes de fréquences TV.

4. Récepteur radio (1) selon l'une des revendications précédentes, **caractérisé en ce que** la fréquence du signal d'oscillateur correspond à un multiple du signal de commande du mélangeur (3a, 3b) et il est prévu au moins un diviseur de fréquence pour abaisser la fréquence du signal d'oscillateur à la fréquence d'oscillateur (f_{0,1}, f_{0,2}).

5. Récepteur radio (1) selon la revendication 4, **caractérisé en ce que** le rapport de division du diviseur de fréquence (9a, 9b) est un nombre entier ou un rationnel fractionnaire.

6. Récepteur radio (1) selon la revendication 5, **caractérisé en ce que** l'oscillateur 4a, 4b est utilisé avec une PLL à N fractions lorsque le rapport de division est un rationnel fractionnaire.
